# FASCICULE DE BREVET EUROPEEN

(11) **EP 1 784 866 B1**
(45) Date de publication et mention de la délivrance du brevet: **05.06.2019**
(21) Numéro de dépôt: 05790848.5
(22) Date de dépôt: 19.07.2005
(51) Int. Cl.: H01L 27/30, H01L 51/42

(54) **DISPOSITIF SEMICONDUCTEUR à NANOTUBE OU NANOFIL, CONFIGURABLE OPTIQUEMENT**
OPTISCH KONFIGURIERBARE NANORÖHREN- ODER NANODRAHT-HALBLEITEREINRICHTUNG
OPTICALLY-CONFIGURABLE NANOTUBE OR NANOWIRE SEMICONDUCTOR DEVICE

(30) Priorité: 20.07.2004 FR 0408043
(43) Date de publication de la demande: 16.05.2007
(73) Titulaire: Commissariat à l'Énergie Atomique et aux Énergies Alternatives, 75015 Paris (FR)
(72) Inventeur: BORGHETTI, Julien, F-94230 CACHAN (FR); BOURGOIN, Jean-Philippe, F-78960 VOISINS LE BRETONNEUX (FR); MORDANT, Pascale, F-91140 VILLEBON SUR YVETTE (FR); DERYCKE, Vincent, F-78180 MONTIGNY LE BRETONNEUX (FR); FILORAMO, Arianna, F-78470 SAINT REMY LES CHEVREUSE (FR); GOFFMAN, Marcelo, F-91120 PALAISEAU (FR)
(74) Mandataire: Gevers & Orès
(86) Numéro de dépôt international: PCT/FR2005/001840
(87) Numéro de publication internationale: WO 2006/018497

(56) Documents cités:
- WO-A-03/029354
- FR-A- 2 849 437
- SHIM M ET AL: "PHOTOINDUCED CONDUCTIVITY CHANGES IN CARBON NANOTUBE TRANSISTORS" APPLIED PHYSICS LETTERS, AMERICAN INSTITUTE OF PHYSICS. NEW YORK, US, vol. 83, no. 17, 27 octobre 2003 (2003-10-27), pages 3564-3566, XP001192562 ISSN: 0003-6951
- KYMAKIS E ET AL: "Photovoltaic cells based on dye-sensitisation of single-wall carbon nanotubes in a polymer matrix" SOLAR ENERGY MATERIALS AND SOLAR CELLS, ELSEVIER SCIENCE PUBLISHERS, AMSTERDAM, NL, vol. 80, no. 4, décembre 2003 (2003-12), pages 465-472, XP004470055 ISSN: 0927-0248
- ADACHI M ET AL: "FORMATION OF TITANIA NANOTUBES AND APPLICATIONS FOR DYE-SENSITIZED SOLAR CELLS" JOURNAL OF THE ELECTROCHEMICAL SOCIETY, ELECTROCHEMICAL SOCIETY. MANCHESTER, NEW HAMPSHIRE, US, vol. 150, no. 8, août 2003 (2003-08), pages G488-G493, XP008052152 ISSN: 0013-4651
- RAVINDRAN S ET AL: "Covalent coupling of quantum dots to multiwalled carbon nanotubes for electronic device applications" NANO LETTERS AMERICAN CHEM. SOC USA, vol. 3, no. 4, avril 2003 (2003-04), pages 447-453, XP008055339 ISSN: 1530-6984

## Description

La présente invention a pour objet un dispositif semiconducteur à nanotube ou nanofil, tel qu'un transistor ou une diode, qui soit configurable optiquement et son utilisation dans des circuits électroniques reconfigurables optiquement.

L'article de R. J. CHEN et Collaborateurs intitulé « Molecular Desorption from single-walled carbon nanotubes » et qui est paru dans Applied Physics Letters volume 79 n° 14, 2258 (2001) indique qu'un puissant éclairement dans l'ultra-violet ou le visible peut modifier les caractéristiques électriques d'un transistor à nanotube en désorbant les molécules d'oxygène présentes sur les électrodes. Ce phénomène est rapide mais en ce qui concerne sa réversibilité il faut en général plusieurs dizaines de minutes pour rétablir le courant initial. Ce phénomène qui nécessite beaucoup de puissance, n'est pas spécifique en longueur d'onde et est difficilement réversible.

L'article de K. BALASUBRAMANIAN et Collaborateurs intitulé « Photoelectronic transport imaging of individual semiconducting carbon nanotubes » paru dans Applied Physics Letters volume 84 n° 13 (2004) indique que des photons dont la longueur d'onde se situe à 514,5 nm et/ou à 647,1 nm peuvent générer un photo-courant dans un transistor à nanotube de carbone non fonctionnalisé : les courants générés sont très faibles (<1 nA) et détectables uniquement dans l'état bloqué (« Off ») du transistor.

L'article de FREITAG et Collaborateurs « Photoconductivity of Single Carbon Nanotubes » parus dans Nano Letters volume 3 n° 8, pages 1067 - 1071 (2003) indique qu'un transistor à base de nanotubes peut être utilisé comme détecteur dé photons infrarouges. Le courant dans un transistor à nanotube peut être modifié par des photons, à condition que la longueur d'onde de cette lumière corresponde à l'énergie d'une des transitions permises entre singularités de Van Hove, (par exemple, la bande interdite) du nanotube semiconducteur servant de canal au transistor. Cette longueur d'onde se trouve dans l'infra-rouge pour les deux premières transitions accessibles en général. Elle est définie de façon définitive par la structure atomique du nanotube (diamètre et chiralité).

Les modifications des caractéristiques électriques d'un transistor à base de nanotubes en présence de lumière mises en évidence sont très faibles. Elles peuvent être utilisées pour détecter un rayonnement infra-rouge, mais le transistor n'est pas réellement « commandé optiquement ». Seul le courant dans l'état bloqué varie et dans des proportions très faibles. Enfin, le processus utilisé (la création directe de paires électron-trou à travers la bande interdite du nanotube non fonctionnalisé) possède un rendement quantique très faible (de l'ordre de 10⁻⁷).

L'article de A. STAR et Collaborateurs intitulé « Nanotube Optoelectronic Memory Devices », qui est paru dans Nano Letters de Juin 2004 indique qu'en fonctionnalisant un dispositif à base de nanotubes de carbone avec un polymère photo-sensible, on pouvait réaliser une fonction mémoire. A cet effet, un ensemble de nanotubes est couvert d'un film épais de polymère (goutte déposée sur la puce). Il s'agit donc de polymères (très grosses molécules) déposés de manière non contrôlée sous forme de couches très épaisses. Lorsque le dispositif est éclairé, la caractéristique électrique Id(Vgs) est décalée, ce qui indique que des électrons ont été transférés vers le polymère. Lorsque l'éclairement est stoppé, le dispositif conserve sa caractéristique pendant un temps très long (plusieurs minutes), d'où un effet « mémoire ». Cette technique est limitée à des caractéristiques de type « mémoire » et n'est pas compatible avec une intégration dense.

L'article de ROTKIN et ZMAROV « Nanotube light-controlled electronic switch » paru dans International Journal of Nanoscience vol. 1 n° 3 et 4 (2002), pages 347 - 355 propose de déplacer une charge électrique à proximité d'un nanotube de carbone en utilisant une molécule à changement de conformation. Lors de l'adsorption d'un photon, cette molécule se déforme. Selon cette étude théorique, si cette molécule porte une charge à son extrémité la plus éloignée du tube, cette charge pourrait être mécaniquement approchée ou éloignée du tube, ce qui pourrait modifier les caractéristiques du dispositif. En tout état de cause, cette technique nécessite la mise en oeuvre de molécules à changement de conformation.

L'article de RAVINDRAN et Collaborateurs intitulé « Covalent Coupling of Quantum Dots to Multiwalled Carbon Nanotubes for Electronic Device Applications », qui est paru dans NANO LETTERS 2013 Vol.3, N°4 447-453, illustre la conjugaison d'un nanotube multi-parois à des nanocristaux recouverts de ZnS. Ces nanocristaux forment des « quantum dots » lesquels sont des nanocristaux semiconducteurs, qui sont ensuite utilisés pour former des hétérojonctions avec le nanotube.

On pourra aussi considérer le document WO 03/029354 ou les articles de :
- M. Shim, G.P. Siddons, Appl. Phys. Lett. 83 (2003) 3564-3566,
- E. Kymakis, G. A. J. Amaratunga, Sol. Energy Mat. & Solar Cells 80 (2003) 465-472,
- M. Adachi, Y. Murata, l. Okada, S. Yoshikawa, J. Electrochem. Soc. 150 (2003) G488-G493,
- S. Ravindran, S. Chaudhary, B. Colburn, M. Ozkan, C. S. Ozkan, Nano Lett. 3 (2003) 447-453,
lesquels se réfèrent au domaine technique considéré.

La présente invention a pour objet un dispositif semi-conducteur à nanotube ou nanofil, notamment de carbone, qui soit configurable optiquement avec un rendement quantique favorable et qui soit réversible, sans effet mémoire notable, c'est-à-dire que les dispositifs retrouvent leur état initial lorsque l'éclairement cesse. Avantageusement, le dispositif est configurable optiquement avec une lumière dont la longueur d'onde est sélectionnée en fonction du matériau photo-sensible choisi.

L'invention concerne un dispositif semiconducteur à nanotube ou nanofil, notamment de carbone, ainsi que des éléctrodes, caractérisé en ce qu'il comporte au moins une région en partie recouverte d'au moins une couche de préférence ordonnée de molécules ou de nanocristaux d'un matériau photo-sensible.

Il est avantageux que les molécules soient amphiphiles.

Le matériau peut être notamment une phtalocyanine, présentant un atome central métallique, notamment du cuivre, une porphyrine, une azoporphyrine ou ses dérivés, ou bien encore un colorant ou un chromophore notamment amphiphile. En variante, ce peut être un nanocristal de matériau semi-conducteur.

Le matériau peut être sous forme d'un film mince, qui comporte par exemple entre 1 et 20, et plus particulièrement entre 1 et 10, couches moléculaires du matériau.

La région dans laquelle le matériau est déposé peut être une surface externe et/ou interne du nanotube ou du nanofil, ou bien une électrode du dispositif semi-conducteur ou bien encore la surface d'un diélectrique de grille d'un transistor, ou bien encore la surface d'un substrat sur lequel est disposé le nanotube ou nanofil.

Le dispositif peut présenter une ou plusieurs régions recouvertes d'au moins une dite couche de matériaux photo-sensibles différents.

L'invention concerne également un procédé de commande d'un dispositif semiconducteur tel que défini ci-dessus, caractérisé en ce qu'il met en oeuvre un éclairement d'au moins une dite région par une lumière de longueur d'onde située dans une région d'absorption de la lumière par ledit matériau.

D'autres caractéristiques et avantages de l'invention apparaîtront mieux à la lecture de la description ci-après en liaison avec les dessins dans lesquels :
- la figure 1a est un exemple d'un transistor à effet de champ à nanotube de carbone dénommé "CNTFET", les figures 1b et 1c constituent des variantes du dispositif, utilisables dans le cadre de la présente invention.
- les figures de 2a à 2c illustrent différentes localisations de la couche photosensible et les effets qui en résultent,
- la figure 3 illustre une série d'essais avec et sans excitation par une lumière laser,
- les figures 4a et 4b représentent la caractéristique de courant de drain Id en fonction de la tension grille-source Vgs d'un transistor respectivement dans le noir et en présence d'un éclairage par un laser rouge (λ = 647,1 nm), ces mêmes courbes étant représentées en coordonnées semi-logarithmiques à la figure 4b,
- les figures 5a à 5f illustrent à l'aide d'une courbe exprimant la tension de drain Id (en nA) en fonction de la tension grille-source Vgs (en Volts), différents effets pouvant être obtenus pour un transistor à nanotube de carbone de type p, avec une gamme de fonctionnement comprise entre -1 V et +1 V pour la tension Vgs,
- les figures 6a à 6c illustrent différents circuits optiquement reconfigurables mettant en oeuvre un ou plusieurs dispositifs selon l'invention.

Les nanotubes de carbone mono-paroi peuvent être, suivant leur structure (chiralité), métalliques ou semi-conducteurs. Ils peuvent être connectés à des électrodes pour former des composants électroniques. Ainsi, de 1996 à 2004, ces nanotubes ont servi d'éléments de base à la fabrication de diodes, de transistors à un électron (« SETs ») et de transistors à effet de champ (« CNTFETs »). Ces CNTFETs (ou Carbon Nanotube Field Effect Transistors) peuvent eux-mêmes servir à fabriquer des éléments de mémoire, des portes logiques élémentaires, des détecteurs de gaz ou de molécules biologiques,ou bien encore des émetteurs et détecteurs de photons infrarouges.

Un transistor à effet de champ de type CNTFET est par exemple constitué d'un nanotube 1 de carbone mono-paroi semi-conducteur connecté par deux électrodes (source S et drain D) et contrôlé par une troisième électrode (grille G) séparée du tube par un isolant 2 (l'oxyde de grille). Le courant entre la source S et drain D, dans le canal que constitue le nanotube 1, est modulé par la tension de grille. Cette géométrie n'est pas la seule possible. En particulier, l'électrode de grille peut se trouver en dessous ou au-dessus du nanotube.

Depuis 1998, les performances de ces composants n'ont cessé de s'améliorer, notamment ces deux dernières années, pour atteindre un niveau comparable aux transistors en silicium.

L'une des particularités importantes de ces composants électroniques à base de nanotubes de carbone est une grande sensibilité à leur environnement. La présence de molécules adsorbées sur les différentes parties de ces composants (tube, électrodes, surface) modifie de façon très sensible leurs propriétés de transport électronique.

L'environnement du transistor « CNTFET » peut modifier la caractéristique électrique de plusieurs façons :
(a) des molécules adsorbées ou chimiquement liées sur le nanotube peuvent transférer des charges au nanotube (donner ou accepter des électrons). Cet échange se traduit par une modification du niveau de dopage du nanotube.
(b) des molécules adsorbées ou chimiquement liées sur les électrodes, à proximité du nanotube, peuvent modifier l'injection des porteurs dans le canal. En effet, pour entrer dans le nanotube, une charge présente dans l'électrode doit généralement franchir une barrière de potentiel (cas d'un contact Schottky). La hauteur de cette barrière est sensible à la présence de certaines molécules, en particulier, les molécules polaires.
(c) l'adsorption de molécules sur le tube, ou sur la surface à proximité du nanotube peut également modifier les caractéristiques électriques du composant sans qu'il y ait de transfert de charge entre la molécule et le nanotube. En particulier, des molécules chargées ou fortement polaires à proximité du tube modifient le potentiel électrostatique au niveau du tube et agissent donc comme une tension appliquée sur la grille (on parle de « chemical gating » ou potentiel de grille induit chimiquement).

Nous appellerons par la suite dopage induit, modification de l'injection et grille à potentiel induit chimiquement ou « chemical gating » les trois exemples de modes d'action décrits ci-dessus.

L'invention vise en particulier à utiliser la lumière pour déclencher, stopper, augmenter, diminuer et/ou inverser ce type d'effets.

De nombreuses classes de molécules présentent des propriétés photo-chimiques ou photo-physiques. De façon très générale, lorsqu'une molécule absorbe un photon, elle passe dans un état excité. Cet excès d'énergie peut avoir plusieurs conséquences. La molécule peut: se dissocier en plusieurs fragments, luminescer, subir une transition non-radiative, être ionisée, changer de conformation, réagir avec d'autres molécules en formant un nouveau composé ou en transférant une charge, transférer son excitation à une autre molécule. Certains de ces mécanismes, en particulier les quatre derniers, peuvent être utilisés pour contrôler les propriétés de transport d'un transistor à nanotube.

### a) dopage photo-induit.

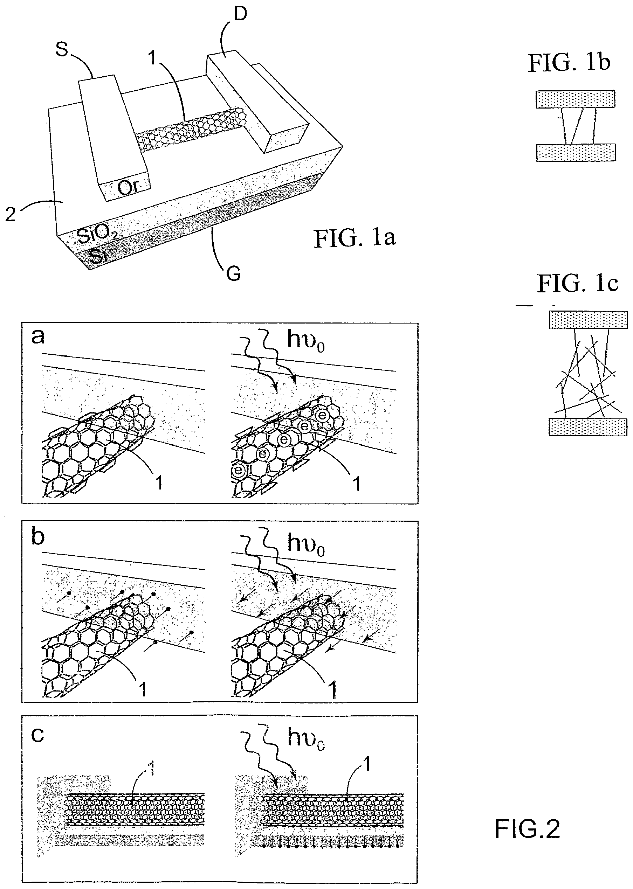

Certaines molécules en solution peuvent donner ou accepter des électrons lors de l'adsorption d'un photon. Dans l'exemple ci-après, des molécules sont adsorbées sur le tube qui lui transfèrent des charges lorsqu'elles sont dans l'état excité (Fig. 2a). Il en résulte un changement du niveau de dopage du canal du transistor.

On peut également utiliser les propriétés optiques remarquables des nanocristaux de semiconducteurs (typiquement CdSe). L'absorption d'un photon par un nanocristal semiconducteur conduit à la formation d'une paire électron-trou (exciton). On peut alors observer un transfert de charge vers les molécules présentes à la surface du nanocristal. Un transfert de trous est ainsi observé lorsque la surface du nanocristal est fonctionnalisée avec des molécules à caractère réducteur telles que les thiols ou des composés poly-aromatiques. Des nanocristaux semiconducteurs greffés sur le nanotube (éventuellement via une fonctionnalisation préalable de sa surface) ou déposés à proximité immédiate devraient donc permettre un dopage photo-induit. Une autre propriété intéressante des nano-cristaux est la dépendance de leur spectre d'absorption en fonction de leur taille et du type de chalcogénure utilisé (CdTe, CdSe, CdS). Il serait ainsi possible de sélectionner la longueur d'onde de la radiation induisant l'effet de photo-dopage en utilisant des nano-cristaux de diamètres ou de compositions différents.

### b) Modification photo-induite de l'injection de charges.

Il est connu que certaines molécules voient leur structure chimique modifiée par l'absorption d'un photon. Il peut en résulter, en particulier, un changement de moment dipolaire électrique si la répartition des centres de charges positives et négatives différent d'un état à l'autre. Si de telles molécules sont greffées sur les électrodes d'un transistor CNTFET (Fig. 2b), l'injection des porteurs dans le nanotube sera sensible à l'état de la molécule, donc à la lumière.

### c) Potentiel de grille photo-induit.

On peut également utiliser de telles molécules greffées sur le nanotube ou sur la surface de l'oxyde de grille (Fig. 2c). L'adsorption d'un photon modifie alors l'environnement électrostatique du nanotube et a ainsi un effet comparable à celui de l'électrode de grille (« chemical gating »).

### Exemple de réalisation : transistor à nanotube de carbone dont les caractéristiques électriques peuvent être modulées par la lumière.

Dans cet exemple, le transistor à nanotube est recouvert d'un film de Langmuir-Blodgett de phtalocyanine dénommé CuS18. Les molécules chromophores utilisées sont des phtalocyanines amphiphiles, contenant un coeur chromophore chargé positivement muni de 4 chaînes aliphatiques en C18 (18 atomes de carbone). Le CuS18 est un composé décrit en 1986 par Serge PALACIN dans la référence : S. PALACIN, A. RUAUDEL-TEIXIER, A. BARRAUD, J. Phys. Chem., 90, 6237-6242 (1986). Le nom « CuS18 » vient d'un système de dénomination d'une série de composés de structures similaires. Le nom complet est bromure de tétraoctadécyltétrapyridino[3,4-b : 3',4'-g : 3",4"-I : 3"',4"'-q]porphyrazinium.

La taille typique des molécules est 1,7 nm de diamètre pour le coeur chromophore avec des chaînes de 2,0 nm liées aux bords et mobiles. La technique de dépôt par film de Langmuir-Blodgett permet de contrôler précisément la quantité de molécules déposée (monocouche par monocouche) par superposition de monocouches. L'effet montré ci-dessous a été reproduit avec une seule couche, deux couches et dix couches de molécules sur le transistor. On peut en pratique superposer par exemple jusqu'à environ vingt monocouches, voire plus.

L'invention ne se limite nullement à l'utilisation de couches déposées par la technique de Langmuir-Blodgett. Il existe d'autres méthodes de dépôt de couches connues de l'homme du métier telles que le dépôt chimique en phase vapeur CVD, etc.... Il est également possible de fonctionnaliser les nanotubes avant leur assemblage au sein des dispositifs.

Sous éclairement laser à une longueur d'onde donnée (ici 647,1 nm) correspondant à un maximum d'absorption dans le spectre de la molécule, ce qui confère une sélectivité en longueur d'onde dépendant de la molécule utilisée, les molécules en contact avec le tube transfèrent des électrons au tube et se trouvent chargés positivement. La présence de ces molécules chargées positivement provoque une diminution de la densité de charges positives (trous) dans le tube. Ces trous étant responsables du courant dans le transistor pour des tensions de grille négatives, une diminution de leur nombre se traduit par une nette diminution du courant dans le transistor lorsqu'il est éclairé.

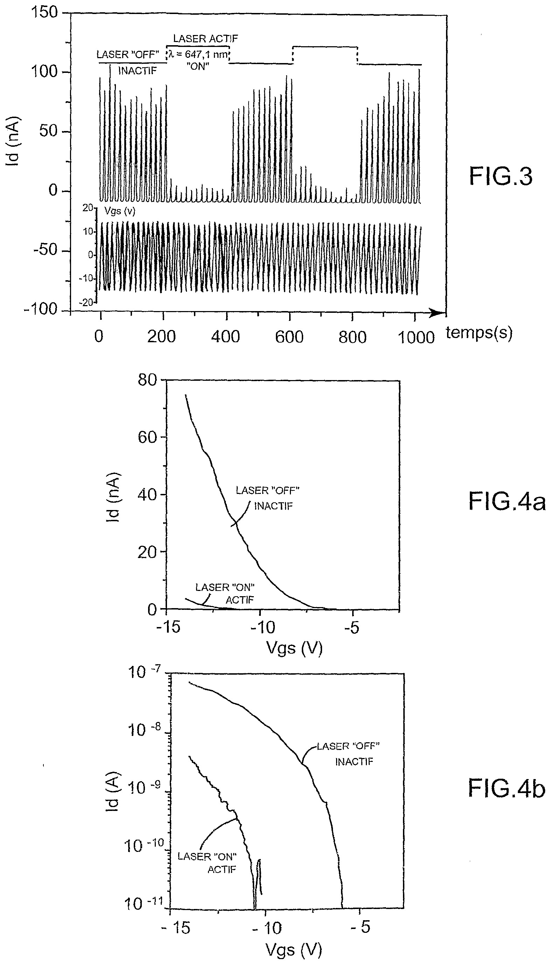

Pour montrer la dynamique du phénomène, on présente Fig. 3 un ensemble de courbes en fonction du temps et suivant des cycles de balayage de la tension Vgs. Il s'agit d'une série de caractéristiques Id(Vgs) enchaînées. On observe une chute brutale du courant lorsque le laser est allumé. Ce qui est particulièrement remarquable est la réversibilité rapide du phénomène.

D'autres travaux notamment ceux cités ci-dessus ont montré des phénomènes photo-induits difficilement réversibles : la photo-désorption de molécules depuis les électrodes du transistor et le stockage de charges dans un polymère photo-sensible. Le fait que les courbes de la Fig. 3 retrouvent leur caractère initial dès l'extinction du laser montre clairement qu'il s'agit d'un autre mécanisme. La puissance du laser a été augmentée expérimentalement jusqu'à atteindre le phénomène de photo-désorption. Il existe une large gamme de puissance permettant d'observer uniquement le phénomène intéressant à dynamique rapide avant d'arriver au seuil de photo-désorption.

La figure 4a montre la caractéristique Id(Vgs) du transistor dans le noir et lorsqu'il est éclairé par un laser rouge (λ=647,1 nm), en moyennant les enregistrements Id(Vgs) correspondant aux courbes de la figure 3. On voit très clairement que cette caractéristique est drastiquement modifiée par les photons en particulier dans l'état passant « ON » (ce qui est une différence importante avec l'art antérieur).

Pour visualiser également l'état bloqué « OFF », les mêmes courbes sont présentées à la Fig. 4b en échelle semi-logarithmique. On voit clairement que pour des tensions de grilles supérieures à la tension de seuil, l'état bloqué « OFF » est également nettement modifié.

Enfin, il est important de noter la robustesse du phénomène. Il est possible de cycler le laser un très grand nombre de fois sans dégrader la couche moléculaire.

L'invention permet de maximiser les interactions entre des molécules relativement petites (en comparaison des molécules de polymères) et des nanotubes en travaillant sur des quantités très faibles allant jusqu'à une seule couche moléculaire, ce qui donne accès à des effets électriques rapides et potentiellement localisés, ce qui permet d'utiliser des transistors dans des circuits reconfigurables et intégrés.

Un tel transistor peut être utilisé pour fabriquer un circuit optiquement reconfigurable. En effet, il se comporte comme un interrupteur commandé par la lumière. Si l'on fixe la tension Vgs à une valeur négative (par exemple -10V pour le cas particulier de la figure 4), en présence d'éclairement, le transistor bloque le courant (bien visible en échelle logarithmique : Id <<10⁻¹¹A). Si ce composant est placé à l'entrée d'un sous-circuit, ce sous-circuit sera activé en absence de lumière et désactivé en présence de lumière.

Dans le cadre de la présente invention, on peut mettre en oeuvre un seul nanotube ou nanofil semiconducteur (comme à la figure 1a) ou bien un ensemble de nanotubes et/ou nanofils dont au moins un est semiconducteur, connectés entre deux électrodes (de source S et de drain D pour un transistor - figure 1b) ou bien encore un ensemble de nanotubes et/ou nanofils dont au moins un est semiconducteur et fournissant un chemin entre les électrodes (de source et de drain pour un transistor - figure 1c), aucun tube considéré individuellement ne connectant les deux électrodes.

Les variantes des figures 1b et 1c mettent à profit la mobilité élevée des charges dans les nanotubes de carbone (jusqu'à 79 000 cm²/V/s, par opposition à des valeurs de 10⁻³ à 10⁻¹ cm²/V/s dans les matériaux organiques).

D'autres molécules peuvent être mises en oeuvre :
- les autres phtalocyanines, dans lesquelles l'atome central peut être un métal autre que le cuivre, et/ou dans lequel les chaînes aliphatiques peuvent être remplacées par une autre chaîne,
- les porphyrines, les azoporphyrines et leurs dérivés,
- tout type de fluorophore ou de chromophore, y compris les nanocristaux semi-conducteurs, par exemple de CdTe, CdSe ou de CdS. Les nanocristaux peuvent être utilisés tels quels ou modifiés en les entourant soit d'une coquille en un autre matériau (par exemple ZnSe), soit d'une enveloppe de molécules. Le ZnSe par exemple permet d'éviter qu'un photon absorbé ne soit réémis.

Plusieurs techniques de dépôt peuvent être mises en oeuvre pour déposer les molécules ci-dessus.

La première consiste à déposer un nombre contrôlé de couches moléculaires (une ou plusieurs) sur un transistor existant, comme dans l'exemple ci-dessus. On peut en particulier utiliser les molécules amphiphiles suivantes :
- les phtalocyanines à atome central métallique pour lesquelles des chaînes grasses en C18 ou de longueur différente assurent le caractère amphiphile,
- des porphyrines, azoporphyrines et leurs dérivés amphiphiles.
- tout colorant ou chromophore amphiphile.

La deuxième technique qui met en oeuvre une liaison covalente ou non covalente, consiste en un dépôt d'un nombre contrôlé de couches moléculaires (typiquement une seule) par chimisorption ou physisorption sur un transistor existant.

La troisième technique consiste en un assemblage nanotubes-molécules en solution, mettant en oeuvre des liaisons covolentes ou non, ces nanotubes étant alors couverts d'un petit nombre de molécules, typiquement une seule couche. Ces nanotubes pourront être utilisés pour fabriquer des transistors (ou des diodes) a posteriori.

Ces trois techniques sont compatibles avec la réalisation de circuits denses répondant à plusieurs longueurs d'onde. Dans les deux premiers cas, les circuits sont réalisés avant les associations nanotubes-molécules. En réalisant des masquages successifs de certaines parties d'un circuit, il est possible de déposer des molécules différentes sur des transistors (ou des parties de circuits) différents. Alternativement, on peut utiliser les techniques de type « dip pen » pour fonctionnaliser différents transistors avec différentes molécules. Cette technique (largement documentée dans la littérature par exemple PINER et Collaborateurs C.A. Science 1999, 283, 661 ou bien HONG et Collaborateurs C.A. Science 1999, 286, 523 ou bien encore HONG et Collaborateurs C.A. Science 2000, 288, 1808) consiste à utiliser les molécules comme de « l'encre » et la pointe d'un microscope à force atomique, AFM comme une « plume ». Une pointe d'un microscope AFM est approchée d'une réserve de molécules, puis du dispositif à modifier. Dans certaines conditions, les molécules peuvent migrer depuis la pointe du microscope AFM vers la surface à proximité.

Alternativement, la fonctionnalisation chimique sélective des transistors pourrait être réalisée par électro-greffage. En mettant un circuit en contact avec un réactif (par exemple en l'immergeant) et en polarisant électriquement un (ou plusieurs) transistor(s), on peut fonctionnaliser spécifiquement ce(s) transistor(s) sans affecter ceux qui ne sont pas polarisés. En changeant de réactifs et de transistors polarisés, on peut réaliser plusieurs fonctionnalisations sélectives sur un même circuit.

Pour ce qui concerne le dépôt sur des électrodes on notera que toutes les molécules chromophores terminées par un groupement thiol (SH) peuvent être greffées sur des électrodes d'or par la formation d'une liaison or-soufre. En ce qui concerne la grille, on peut utiliser des procédés de fonctionnalisation de l'oxyde de silicium par des molécules de type chloro-silane ou ethoxy-silane, ce qui est compatible avec la réalisation de transistors à nanotube de carbone. On se référera en particulier aux publications suivantes :
- K. H. CHOI, J.P. BOURGOIN, S. AUVRAY, D. ESTEVE, G.S. DUESBERG, S. ROTH, BURGHARA, Surface Science 462, 195 (2000).
- E. VALENTIN, S. AUVRAY, A. FILORAMO, A. RIBAYROL, M. GOFFMAN, L. CAPES, J.P. BOURGOIN, J.N. PATILLON, Mat. Res. Soc. Symp. Proc. 772, M4.7.1 (2003).

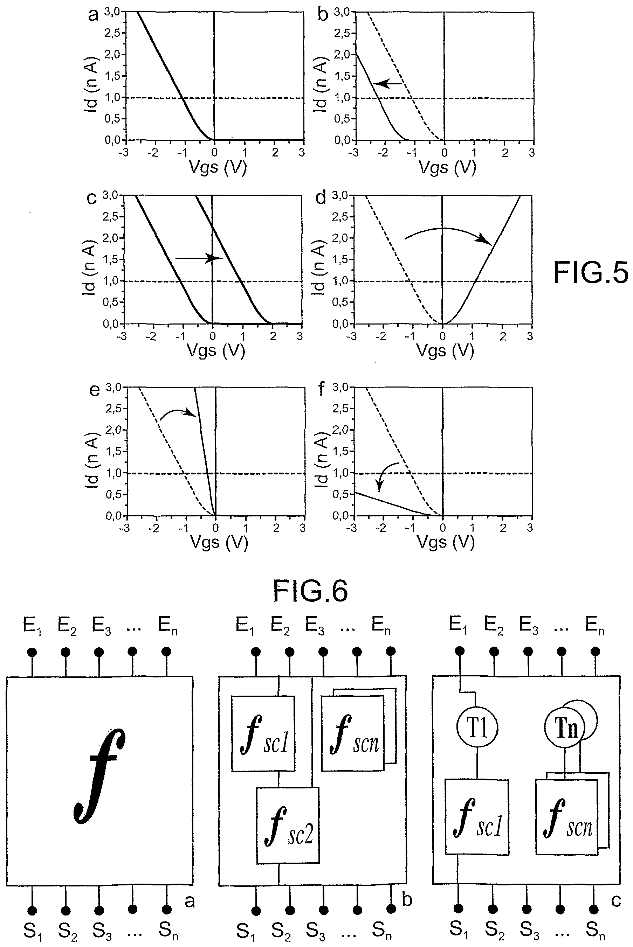

- Les figures 5a à 5f illustrent les différents effets susceptibles d'être obtenus sur un transistor de type p, la gamme d'utilisation étant fixée entre des tensions grille/source Vgs comprises entre -1 V et +1 V, à titre d'exemple. Des effets analogues seraient obtenus avec un transistor de type n.
- Fig. 5a : transistor au repos (non éclairé)
- Fig. 5b : l'effet de la lumière fait que le transistor reste à l'état bloqué « Off » dans toute la gamme d'utilisation. Ceci correspond au cas des molécules donneuses d'électron comme dans l'Exemple ci-dessus.
- Fig. 5c : l'effet de la lumière est tel que le transistor est toujours passant « ON » dans la gamme d'utilisation. Ceci correspond à des molécules acceptrices d'électrons.
- Fig 5d : l'effet de la lumière est tel que le transistor de type p est transformé en transistor de type n. Ceci correspond à des molécules donneuses d'électron, pour lesquels le courant de trous est supprimé pour Vgs < 0 comme dans le cas de la Fig. 5b, mais avec lesquelles un courant d'électrons apparaît également pour Vgs > 0.
- Fig 5e : l'effet de la lumière est tel que la transconductance est améliorée. Ceci correspond à une diminution de la hauteur de la barrière de Schottky augmentant l'injection des trous.
- Fig. 5f : l'effet de la lumière est tel que la transconductance est diminuée. Ceci correspond à une augmentation de la hauteur de la barrière de Schottky limitant l'injection des trous.

En résumé, les effets représentés aux Fig. 5b à 5d correspondent à un « dopage » alors que ceux des Fig. 5e et 5f correspondent à une modification de l'injection par modification des électrodes.

La longueur d'onde de la lumière qui commande les transistors est sélectionnée en fonction de leur absorption par les molécules utilisées. Elle peut donc être choisie, et ce, dans une large gamme (en fonction des matériaux) incluant le visible et le proche ultra-violet. Cette possibilité d'ajuster la longueur d'onde de commande par un paramètre extérieur au nanotube est la clé de l'utilisation de cette commande pour la réalisation de circuits. En effet, elle permet d'envisager des circuits contenant plusieurs transistors fonctionnalisés par des molécules différentes et réagissant à des longueurs d'onde différentes.

L'invention concerne également un circuit électronique reconfigurable comprenant au moins un dispositif semiconducteur tel que défini ci-dessus couplé à au moins un dispositif d'éclairement apte à modifier au moins un paramètre électronique et/ou la fonction dudit dispositif semiconducteur.

On peut considérer de façon fonctionnelle (figure 6) un circuit électronique comme une "boîte noire" transformant un ensemble de signaux électriques d'entrée (E1 à En) en un ensemble de signaux de sortie (S1 à Sn). La fonction du circuit est la fonction *f* qui relie les signaux de sortie aux signaux d'entrée. Le circuit global peut contenir des sous-circuits qui travaillent sur un nombre restreint de signaux d'entrée et fournissent un ensemble restreint de signaux de sortie intermédiaires.

Le circuit est optiquement reconfigurable si la fonction globale *f* varie en fonction de l'éclairement (présence ou absence d'éclairement, intensité I, longueur d'onde λ). Pour cela, on peut considérer plusieurs configurations :
- le circuit (Fig. 6a) est un circuit simple. Il n'est pas nécessaire de le concevoir comme un ensemble de sous-circuits. *f* est fonction de l'éclairement : *f*(I, λ).
- le circuit (Fig. 6b) est composé de sous-circuits répondant chacun différemment à la lumière: *f*_{scn}(I*ₙ*, λ*ₙ*). Eventuellement, certains sous-circuits peuvent ne pas être sensibles à la lumière. Dans cette option, chaque sous-circuit est fonctionnalisé avec un type de molécules différent.
- le circuit (Fig. 6c) est composé de sous circuits ne répondant pas à la lumière mais leur activation est contrôlée par des transistors de contrôle (T₁ à Tₙ) qui sont eux, photo-sensibles. Dans cette option, seuls les transistors de contrôle sont fonctionnalisés chimiquement pour être rendus photo-sensibles à une ou plusieurs longueurs d'onde choisies.

## Revendications

1. Dispositif semiconducteur comprenant au moins un nanotube ou un nanofil semiconducteur, ainsi qu'au moins deux électrodes, le nanotube ou le nanofil semiconducteur a au moins une région au moins en partie recouverte d'au moins une couche de molécules ou de nanocristaux d'au moins un matériau photo-sensible, **caractérisé en ce que** ledit matériau étant sous forme d'un film mince ou d'une mono-couche moléculaire greffée de manière covalente ou non covalente, une liaison électrique entre lesdites deux électrodes étant réalisée par au moins un nanotube ou nanofil, à savoir ledit nanotube ou nanofil semiconducteur et éventuellement au moins un autre nanotube ou nanofil.

2. Dispositif selon la revendication 1, **caractérisé en ce que** lesdites molécules sont amphiphiles.

3. Dispositif selon une des revendications 1 ou 2, **caractérisé en ce que** ledit matériau est une phtalocyanine présentant un atome central métallique.

4. Dispositif selon la revendication 3, **caractérisé en ce que** ledit atome central est du cuivre.

5. Dispositif selon une des revendications 3 ou 4, **caractérisé en ce que** le phtalocyanine présente des chaînes aliphatiques.

6. Dispositif selon une des revendications 1 ou 2, **caractérisé en ce que** ledit matériau est une porphyrine, une azaporphyrine ou ses dérivés.

7. Dispositif selon une des revendications 1 ou 2, **caractérisé en ce que** ledit matériau est un colorant ou un chromophore.

8. Dispositif selon une des revendications précédentes, **caractérisé en ce qu'**au moins une dite couche est ordonnée.

9. Dispositif selon la revendication 1, **caractérisé en ce que** ledit matériau est un nano-cristal semi-conducteur.

10. Dispositif selon une des revendications précédentes, **caractérisé en ce qu'**une dite région est une surface externe et/ou interne du nanotube semiconducteur ou du nanofil semiconducteur.

11. Dispositif selon une des revendications précédentes, **caractérisé en ce qu'**une dite région est une électrode du dispositif semi-conducteur.

12. Dispositif selon une des revendications précédentes, **caractérisé en ce qu'**il comporte un nanotube semiconducteur ou un nanofil semiconducteur pourvu desdites électrodes.

13. Dispositif selon une des revendications précédentes, **caractérisé en ce qu'**il constitue un transistor.

14. Dispositif selon la revendication 13, **caractérisé en ce qu'**une dite région est une surface d'un diélectrique de grille du transistor.

15. Dispositif selon la revendication 13, **caractérisé en ce qu'**une dite région est une surface d'un substrat sur lequel est disposé au moins ledit nanotube semiconducteur ou nanofil semiconducteur.

16. Dispositif selon la revendication 11, **caractérisé en ce que** le dispositif semi-conducteur est une diode.

17. Dispositif selon une des revendications précédentes, **caractérisé en ce qu'**il comporte au moins deux dites régions recouvertes d'au moins une dite couche de matériaux photo-sensibles différents.

18. Dispositif selon une des revendications précédentes, **caractérisé en ce qu'**il comporte un ou plusieurs nanotubes de carbone.

19. Dispositif selon une des revendications précédentes, **caractérisé en ce qu'**il comporte un ou plusieurs nanotubes monoparoi, pour former un transistor à effet de champ de type CNTFET.

20. Dispositif selon une des revendications précédentes, **caractérisé en ce que** le matériau est sous forme de film mince comportant entre 1 et 20 et plus particulièrement entre 1 et 10 couches moléculaires du matériau.

21. Circuit électronique **caractérisé en ce qu'**il comporte au moins un dispositif semiconducteur selon une des revendications précédentes couplé à au moins un dispositif d'éclairement apte à modifier au moins un paramètre électronique et/ou la fonction dudit dispositif semiconducteur.

22. Procédé de commande d'un dispositif semiconducteur selon une des revendications 1 à 19 ou du circuit électronique selon la revendication 21, **caractérisé en ce qu'**il met en oeuvre un éclairement d'au moins une dite région par une lumière de longueur d'onde située dans une région d'absorption de la lumière par ledit matériau.

## Patentansprüche

1. Halbleitervorrichtung, umfassend mindestens eine Nanoröhre oder einen Halbleiter-Nanodraht sowie mindestens zwei Elektroden, wobei die Nanoröhre oder der Halbleiter-Nanodraht mindestens einen Bereich aufweist, der mindestens teilweise von mindestens einer Molekül- oder Nanokristallschicht aus mindestens einem lichtempfindlichen Material bedeckt ist,
**dadurch gekennzeichnet, dass** das Material in Form eines Dünnfilms oder einer Moleküleinzelschicht ist, die auf kovalente oder nicht kovalente Weise gepfropft ist, wobei eine elektrische Verbindung zwischen den zwei Elektroden durch mindestens eine Nanoröhre oder Nanodraht realisiert wird, nämlich die Nanoröhre oder der Halbleiter-Nanodraht und eventuell mindestens eine andere Nanoröhre oder Nanodraht.

2. Vorrichtung nach Anspruch 1, **dadurch gekennzeichnet, dass** die Moleküle amphiphil sind.

3. Vorrichtung nach einem der Ansprüche 1 oder 2, **dadurch gekennzeichnet, dass** das Material ein Phtalocyanin ist, das ein metallisches Zentralatom präsentiert.

4. Vorrichtung nach Anspruch 3, **dadurch gekennzeichnet, dass** das Zentralatom Kupfer ist.

5. Vorrichtung nach einem der Ansprüche 3 oder 4, **dadurch gekennzeichnet, dass** das Phtalocyanin aliphatische Ketten präsentiert.

6. Vorrichtung nach einem der Ansprüche 1 oder 2, **dadurch gekennzeichnet, dass** das Material ein Porphyrin, ein Azoporphyrin oder dessen Derivate ist.

7. Vorrichtung nach einem der Ansprüche 1 oder 2, **dadurch gekennzeichnet, dass** das Material ein Farbstoff oder ein Chromophor ist.

8. Vorrichtung nach einem der vorstehenden Ansprüche, **dadurch gekennzeichnet, dass** mindestens eine Schicht geordnet ist.

9. Vorrichtung nach Anspruch 1, **dadurch gekennzeichnet, dass** das Material ein Halbleiter-Nanokristall ist.

10. Vorrichtung nach einem der vorstehenden Ansprüche, **dadurch gekennzeichnet, dass** ein Bereich eine äußere und/oder innere Oberfläche der Halbleiter-Nanoröhre oder des Halbleiter-Nanodrahts ist.

11. Vorrichtung nach einem der vorstehenden Ansprüche, **dadurch gekennzeichnet, dass** ein Bereich eine Elektrode der Halbleitervorrichtung ist.

12. Vorrichtung nach einem der vorstehenden Ansprüche, **dadurch gekennzeichnet, dass** sie eine Halbleiter-Nanoröhre oder einen Halbleiter-Nanodraht einschließt, der mit den Elektroden ausgestattet ist.

13. Vorrichtung nach einem der vorstehenden Ansprüche, **dadurch gekennzeichnet, dass** sie einen Transistor darstellt.

14. Vorrichtung nach Anspruch 13, **dadurch gekennzeichnet, dass** ein Bereich eine Oberfläche eines Gate-Dielektrikums des Transistors ist.

15. Vorrichtung nach Anspruch 13, **dadurch gekennzeichnet, dass** ein Bereich eine Oberfläche eines Substrats ist, auf dem mindestens die Halbleiter-Nanoröhre oder der Halbleiter-Nanodraht angeordnet ist.

16. Vorrichtung nach Anspruch 11, **dadurch gekennzeichnet, dass** die Halbleitervorrichtung eine Diode ist.

17. Vorrichtung nach einem der vorstehenden Ansprüche, **dadurch gekennzeichnet, dass** sie mindestens zwei der Bereiche einschließt, die von mindestens einer Schicht aus unterschiedlichen lichtempfindlichen Materialien bedeckt sind.

18. Vorrichtung nach einem der vorstehenden Ansprüche, **dadurch gekennzeichnet, dass** sie eine oder mehrere Kohlenstoffnanoröhren einschließt.

19. Vorrichtung nach einem der vorstehenden Ansprüche, **dadurch gekennzeichnet, dass** sie eine oder mehrere einwandige Nanoröhren einschließt, um einen Feldeffekttransistor des Typs CNTFET zu bilden.

20. Vorrichtung nach einem der vorstehenden Ansprüche, **dadurch gekennzeichnet, dass** das Material in Form eines Dünnfilms ist, der zwischen 1 und 20, und insbesondere zwischen 1 und 10 Molekularschichten des Materials einschließt.

21. Elektronischer Schaltkreis, **dadurch gekennzeichnet, dass** er mindestens eine Halbleitervorrichtung nach einem der vorstehenden Ansprüche einschließt, die an mindestens eine Beleuchtungsvorrichtung gekoppelt ist, geeignet, um mindestens einen elektronischen Parameter und/oder den Betrieb der Halbleitervorrichtung zu modifizieren.

22. Steuerverfahren einer Halbleitervorrichtung nach einem der Ansprüche 1 bis 19 oder des elektronischen Schaltkreises nach Anspruch 21, **dadurch gekennzeichnet, dass** es eine Beleuchtung mindestens eines Bereichs durch ein Licht einer Wellenlänge umsetzt, die in einem Absorptionsbereich des Lichtes durch das Material liegt.

## Claims

1. Semiconductor device comprising at least one semiconductive nanotube or nanowire, as well as two electrodes, the semiconductive nanotube or nanowire has at least one region at least partially covered by at least one layer of molecules or nanocrystals of at least one photosensitive material, **characterised in that** said material being in the form of a thin film or of a molecular monolayer grafted in a covalent or non-covalent manner, an electrical connection between said two electrodes is achieved by at least one nanotube or nanowire, namely said semiconductive nanotube or nanowire and possibly at least one other nanotube or nanowire.

2. Device according to claim 1, **characterised in that** said molecules are amphiphilic.

3. Device according to one of claims 1 or 2, **characterised in that** said material is a phthalocyanine having a metallic central atom.

4. Device according to claim 3, **characterised in that** said central atom is copper.

5. Device according to one of claims 3 or 4, **characterised in that** the phthalocyanine has aliphatic chains.

6. Device according to one of claims 1 or 2, **characterised in that** said material is a porphyrin, an azoporphyrin or one of the derivatives thereof.

7. Device according to one of claims 1 or 2, **characterised in that** said material is a dye or a chromophore.

8. Device according to any one of the preceding claims, **characterised in that** at least one said layer is structured.

9. Device according to claim 1, **characterised in that** said material is a semiconductive nanocrystal.

10. Device according to any one of the preceding claims, **characterised in that** said region is an external and/or internal surface of the semiconductive nanotube or of the semiconductive nanowire.

11. Device according to any one of the preceding claims, **characterised in that** said region is an electrode of the semiconductor device.

12. Device according to any one of the preceding claims, **characterised in that** it comprises a semiconductive nanotube or a semiconductive nanowire provided with said electrodes.

13. Device according to any one of the preceding claims, **characterised in that** it constitutes a transistor.

14. Device according to claim 13, **characterised in that** one said region is a dielectric surface of the transistor gate.

15. Device according to claim 13, **characterised in that** one said region is a surface of a substrate on which is deposited at least said semiconductive nanotube or semiconductive nanowire.

16. Device according to claim 11, **characterised in that** the semiconductor device is a diode.

17. Device according to any one of the preceding claims, **characterised in that** it comprises at least two said regions covered by at least one layer of different photosensitive materials.

18. Device according to any one of the preceding claims, **characterised in that** it comprises one or more carbon nanotubes.

19. Device according to any one of the preceding claims, **characterised in that** it comprises one or more single-wall nanotubes, to form a CNTFET-type field effect transistor.

20. Device according to any one of the preceding claims, **characterised in that** the material is in the form of a thin film comprising between 1 and 20, and more particularly between 1 and 10 molecular layers of the material.

21. Electronic circuit **characterised in that** it comprises at least one semiconductor device according to any one of the preceding claims coupled with at least one illuminance device capable of modifying at least one electronic parameter and/or the function of said semiconductor device.

22. Method for controlling a semiconductor device according to any one of claims 1 to 19 or the electronic circuit according to claim 21, **characterised in that** it implements an illuminance of at least one said region with a wavelength light located in the light absorption region by said material.
